(19) Europäisches Patentamt

European Patent Office

Office européen des brevets

(11) **EP 0 817 378 B1**

(12) **FASCICULE DE BREVET EUROPEEN**

(45) Date de publication et mention
de la délivrance du brevet:
**10.12.2003 Bulletin 2003/50**

(51) Int Cl.7: **H03K 3/72**, H03K 3/037

(21) Numéro de dépôt: **97401580.2**

(22) Date de dépôt: **03.07.1997**

(54) **Générateur d'impulsions électroniques programmables en durée et en fréquence**

Generator elektronischer Impulse mit programmierbarer Dauer und Frequenz

Generator of electronic duration and frequency programmable pulses

(84) Etats contractants désignés:
**DE GB IT NL**

(30) Priorité: **05.07.1996 FR 9608417**

(43) Date de publication de la demande:
**07.01.1998 Bulletin 1998/02**

(73) Titulaire: **ATMEL NANTES SA**
**44300 Nantes (FR)**

(72) Inventeurs:
• **Porcher, Michel**
**44240 La Chapelle Sur Erdre (FR)**
• **Chesnais, Stéphane**
**44390 Petit-Mars (FR)**

• **Desuche, Jean**
**44470 Carquefou (FR)**

(74) Mandataire: **Fréchède, Michel**
**Cabinet Plasseraud**
**84, rue d'Amsterdam**
**F-75440 Paris Cédex 09 (FR)**

(56) Documents cités:
**DE-A- 4 037 942**          **FR-A- 2 596 600**
**GB-A- 2 076 571**          **US-A- 4 255 790**

• **RIGBY A: "TEST PATTERN GENERATOR"
ELEKTOR ELECTRONICS, vol. 15, no. 169, 1
juillet 1989, pages 16-19, XP000106107**

**Description**

L'invention définie dans les revendications concerne un générateur d'impulsions électroniques programmables en durée et en fréquence.

Dans le monde industriel actuel, de nombreuses applications nécessitent la mise en oeuvre d'opérations de mesure de temps absolus ou relatifs et de génération d'impulsions électroniques à des instants précis. Ces opérations ou fonctions sont habituellement réalisées par des compteurs, des décompteurs, des générateurs de signaux ou impulsions électroniques modulées en largeur, désignés par PWM en référence au vocable anglo-saxon Pulse Width Modulation ou des synthétiseurs de fréquences. Tous les dispositifs précités comportent une horloge, ou un compteur, ainsi que des circuits électroniques capables d'engendrer des actions d'état dépendantes du temps ou d'événements extérieurs. Ces dispositifs peuvent être utilisés dans des secteurs d'activité très variés et permettent d'engendrer, soit des impulsions électroniques de fréquence ou de rapport cyclique variable, soit, par intégration, des tensions analogiques variables.

A titre d'exemple d'application, on indique que le domaine de la construction automobile utilise des PWM pour la mise en oeuvre de systèmes d'antiblocage de freinage, ABS, de l'affichage de la vitesse, des modules gradateurs de l'intensité d'éclairage, des commandes de moteurs électriques, tels que les moteurs pas-à-pas, et de la télécommande en fréquence.

De même, dans le secteur des télécommunications, les dispositifs PWM peuvent être utilisés pour la synchronisation de systèmes en temps réel, la création d'impulsions électroniques de numérotation (DTMF) ou de sonneries.

Enfin, dans le domaine de l'industrie de production, les dispositifs PWM sont utilisés pour le positionnement des servomoteurs de télécommande, la commande des moteurs et des gradateurs d'éclairage par exemple. Les synthétiseurs de fréquences peuvent servir à la création des sons, à la modulation des signaux transmis sur fils ou fibre optique.

D'une manière générale, les dispositifs PWM connus de l'état de la technique présentent plusieurs sorties, chacune de ces sorties étant le siège d'une commutation individuelle, génératrice d'une impulsion, lorsqu'une base de temps, telle qu'un compteur, atteint en coïncidence la valeur affectée à la sortie considérée. Chaque sortie revient ensuite à son état de commutation complémenté lorsque le compteur atteint sa valeur de comptage périodique finale, désignée par valeur de modulo. Un tel mode opératoire réduit considérablement la flexibilité de ces dispositifs, notamment lorsqu'il est nécessaire, soit d'engendrer des impulsions multiples, trains d'impulsions, soit lorsque les commandes déphasées doivent être engendrées, le déphasage devant, dans un tel cas, être supérieur à l'intervalle de temps compris entre la commutation en coïncidence avec la valeur affectée et la valeur de modulo.

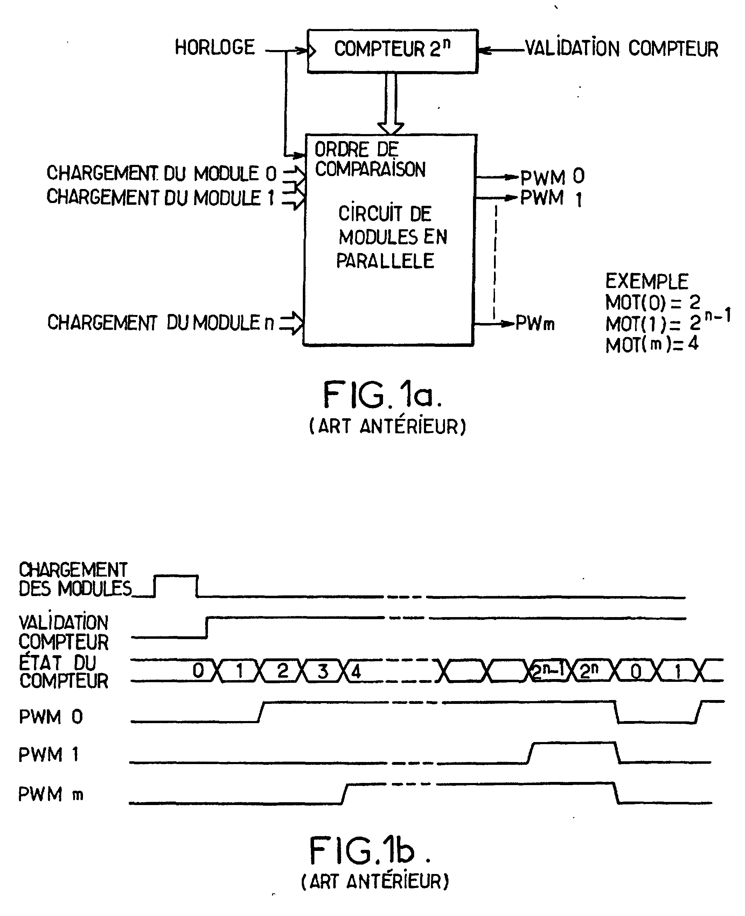

A titre d'exemple de ce type de dispositifs, tels que représentés en figure 1a, ceux-ci comprennent une base de temps, commune à tous les générateurs ou sorties PWM, laquelle est incrémentée à chaque front d'une impulsion d'horloge système. Lorsque le contenu du compteur/base de temps est égal à 0, toutes les sorties PWM passent dans un premier état, alors que lorsque le contenu du compteur/base de temps est égal à la valeur affectée à un générateur ou sortie PWM, cette sortie commute à un deuxième état, complémenté du premier état. Ce processus est effectué par l'intermédiaire d'un comparateur qui commute la sortie lorsque les deux valeurs sont égales. Lorsque la valeur de comptage du compteur atteint sa valeur de modulo, toutes les sorties PWM sont commutées au premier état, et ainsi de suite. Un chronogramme des signaux correspondants est représenté en figure 1b.

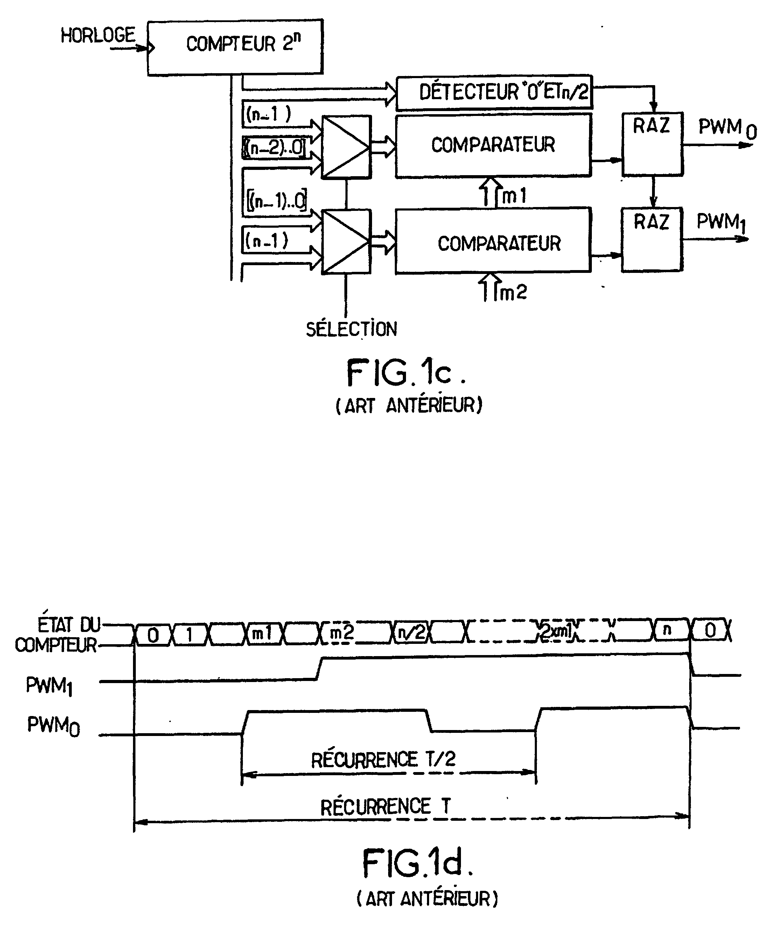

Une amélioration aux dispositifs du type de ceux représentés en figure 1a consiste, ainsi que représenté en figure 1c, à utiliser un compteur/base de temps dont la valeur de modulo est plus grande et à comparer le contenu d'un registre de mémorisation de la valeur d'affectation codée sur n bits du dispositif PWM avec les [n-2, ...,0] bits de poids faibles du compteur et le contenu d'un autre registre d'un autre dispositif PWM avec les n-1 bits de poids fort. En raison du fait que la base de temps réalisée par les n-1 bits de poids faible est deux fois plus rapide que celle réalisée par les n bits, les périodes des sorties PWM correspondantes diffèrent dans un rapport 2. Ce mode opératoire apporte une amélioration par rapport à celui représenté en figures 1a et 1b, la vitesse de comparaison étant, au plus, doublée, mais limite tout de même la flexibilité souhaitée car l'une des sorties est bloquée sur une période T alors que l'autre sortie reste bloquée sur une période T/2.

Enfin, certains dispositifs, plus sophistiqués, permettent de choisir, soit une sortie PWM sur T et l'autre sortie sur T/2, comme dans le cas des figures 1c, 1d, soit les deux sur T, ou encore les deux sur T/2. Toutefois, ces dispositifs restent tout de même soumis à la contrainte temporelle T ou T/2.

Une solution pourrait, le cas échéant, consister à retenir d'autres périodes, sous-multiples de T, mais les limitations de principe demeurent.

Une autre solution pourrait également consister à implanter un compteur/base de temps par sortie PWM. Toutefois, les solutions précitées sont difficilement envisageables dans le cas où l'on étend le nombre de sorties PWM, en particulier dans l'optique d'une réalisation sous forme de circuit intégré, en raison du surcoût en silicium engendré par la multiplication des circuits auxiliaires tels que compteur/base de temps et multiplexeur, laquelle rend quasiment inaccessible l'implantation de ces dispositifs.

La présente invention a pour objet de remédier aux inconvénients précités par la mise en oeuvre d'un générateur PWM, lequel, bien que n'utilisant qu'un seul compteur/base de temps, permet toutefois d'engendrer des impulsions électroniques de largeur et de fréquence programmables.

Un autre objet de la présente invention est en outre la mise en oeuvre d'un tel générateur PWM d'impulsions électroniques programmables en largeur et en fréquence sur une pluralité de sorties distinctes, ce qui permet de conférer à un tel générateur une très grande flexibilité d'utilisation.

Un autre objet de la présente invention est également la mise en oeuvre d'un générateur PWM dans lequel la période d'un train d'impulsions émis est supérieure ou égale à celle du signal d'horloge de référence, horloge système.

Un autre objet de la présente invention est enfin la mise en oeuvre d'un générateur PWM sous forme de circuit intégré, en technologie CMOS, dans lequel le coût en silicium est rendu minimum, en l'absence de multiplication des circuits auxiliaires.

Le générateur d'impulsions électroniques programmables en durée et en fréquence, objet de la présente invention, comprend m sorties $S_j$, $j \in [0,m-1]$, programmables distinctes.

Il est remarquable en ce qu'il comporte au moins un circuit d'initialisation-base de temps piloté par un signal d'horloge de référence et par un signal d'initialisation/comparaison, ce circuit délivrant au moins m valeurs d'initialisation codées sur n bits pour la valeur vraie du signal d'initialisation, chaque bit desdites valeurs d'initialisation étant désigné par $CAM_{ij}$, $i \in [0,n-1]$, respectivement une valeur de comptage périodique codée sur n bits, pour la valeur vraie du signal de comparaison, chaque bit de la valeur de comptage étant désigné par $BL_i$. Un module de décodage d'adresse reçoit une pluralité de valeurs d'adresse $X \in [0,m-1]$ et délivre sur des lignes de mot un bit d'adresse de commande en écriture $WL_{1j}$, $WL_{2j}$. Une matrice de comparaison de bits comportant n x m cellules de comparaison arrangées en m lignes et n colonnes est prévue. Chaque cellule de comparaison $C_{ij}$ comporte une cellule mémoire RAM et une cellule mémoire CAM, cellule mémoire adressable par le contenu, ces cellules mémoire étant adressables en écriture sur les lignes de mot par un bit d'adresse de commande en écriture $WL_{1j}$ et $WL_{2j}$ et recevant chacune pour mémorisation le bit de rang i $BL_i$ de la valeur de comptage. Chaque cellule de comparaison d'adresse i,j permet, d'une part, de mémoriser le bit correspondant $CAM_{ij}$ de la valeur d'initialisation pour la valeur vraie du signal d'initialisation, et, d'autre part, de délivrer une valeur $\overline{CAM_{ij} \oplus BL_i}$, valeur complémentée du produit OU exclusif de ce bit $CAM_{ij}$ de la valeur d'initialisation et du bit $BL_i$ de la valeur de comptage $BL_i$. Chaque cellule mémoire RAM d'adresse i,j délivre une valeur de bit de masquage mémorisée pour la valeur vraie du signal d'initialisation, désignée par $M_{ij}$, et chaque cellule mémoire CAM et RAM de même adresse i,j sont couplées par un couplage logique de type OU, chaque cellule de comparaison $C_{ij}$ délivrant une valeur résultante

$$HIT_{ij} = (\overline{CAM_{ij} \oplus BL_i}) + M_{ij}.$$

Toutes les cellules de comparaison $C_{ij}$ d'une même ligne de rang j sont couplées par une fonction logique de type OU à la sortie correspondante $S_j$, ce qui permet d'effectuer une comparaison entre un mot de n bits stocké dans les cellules mémoire CAM de chaque ligne de rang j pour la valeur vraie du signal d'initialisation avec la valeur de comptage délivrée par le circuit d'initialisation-base de temps piloté pour la valeur vraie du signal de comparaison et d'engendrer ainsi sur chaque sortie $S_j$ une impulsion programmée vérifiant la relation :

$$HIT_j = \sum_{i=0}^{n-1} HIT_{ij} = \sum_{i=0}^{n-1} [(\overline{CAM_{ij} \oplus BL_i}) + M_{ij}]$$

selon un signal périodique dont la période est une période harmonique de la période de la valeur de comptage périodique.

Le générateur d'impulsions électroniques programmables, objet de la présente invention, peut être utilisé dans tous les domaines de l'industrie précédemment mentionnés dans la description.

Il sera mieux compris à la lecture de la description ci-après et à l'observation des dessins dans lesquels, outre les figures 1a à 1d relatives à l'art antérieur,

- la figure 2a représente, sous forme de blocs fonctionnels, un schéma général du générateur d'impulsions électroniques programmables en durée et en fréquence, objet de la présente invention ;
- la figure 2b représente un chronogramme des signaux mis en oeuvre pour la réalisation du mode opératoire du générateur d'impulsions électroniques, objet de la présente invention, selon une phase d'initialisation suivie d'une phase de comparaison ;

- la figure 2c représente, de manière détaillée, un mode de réalisation avantageux d'une cellule de comparaison de bits, constituée par une cellule mémoire RAM et une cellule mémoire CAM adressable par le contenu, un ensemble de cellules de comparaison de bits organisé en matrice permettant la mise en oeuvre du générateur d'impulsions électroniques programmables représenté en figure 2a ;
- la figure 2d représente un chronogramme des signaux mis en oeuvre au niveau d'une cellule de comparaison $C_{ij}$, constituée par une cellule mémoire RAM et une cellule mémoire adressable par le contenu, cellule mémoire CAM ;
- la figure 2e représente, à titre d'exemple non limitatif, un chronogramme d'impulsions électroniques programmées obtenues à partir d'un compteur-décompteur à $2^5$ pour différentes valeurs d'initialisation d'une ligne de cellules de comparaison, en particulier de cellules mémoire CAM ;
- la figure 3a représente une variante de réalisation du générateur d'impulsions électroniques programmables en durée et en fréquence représenté en figure 2a, dans lequel l'une ou moins des lignes de cellules de comparaison a été dédoublée en une première et une deuxième ligne élémentaire de cellules de comparaison, afin de permettre la superposition de trains d'impulsions électroniques distincts engendrés par chaque ligne élémentaire de cellules de comparaison ;
- la figure 3b donne, à titre d'exemple non limitatif, un chronogramme des trains d'impulsions électroniques distincts engendrés par chaque bloc élémentaire de cellules de comparaison, et de leur combinaison suite à leur superposition, pour obtenir un train d'impulsions électroniques résultant.

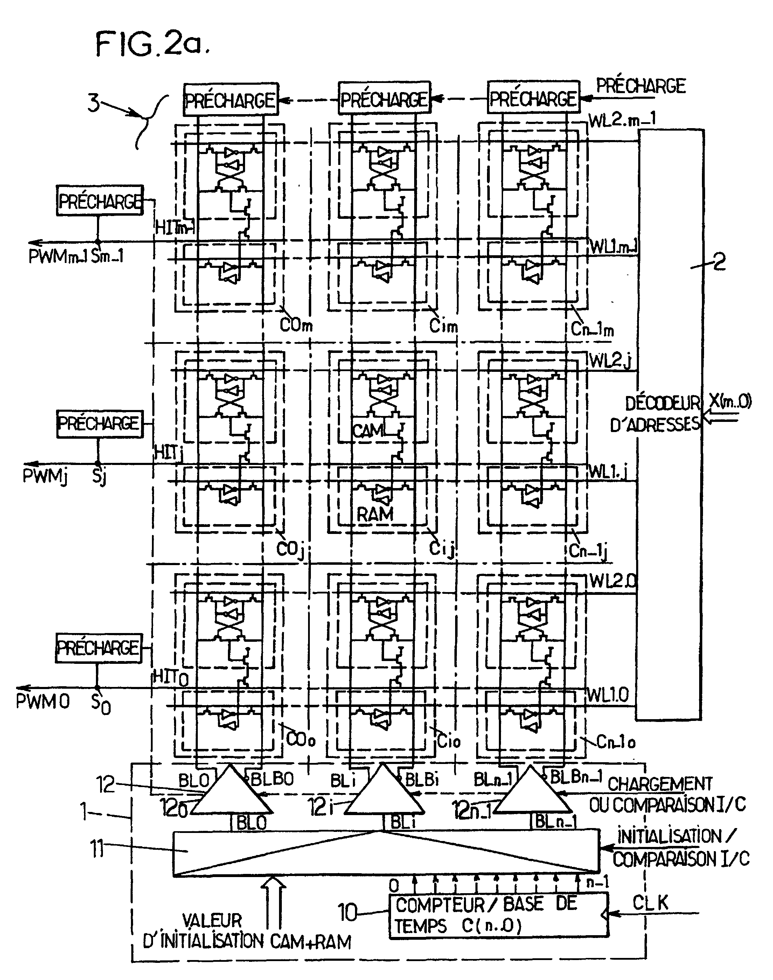

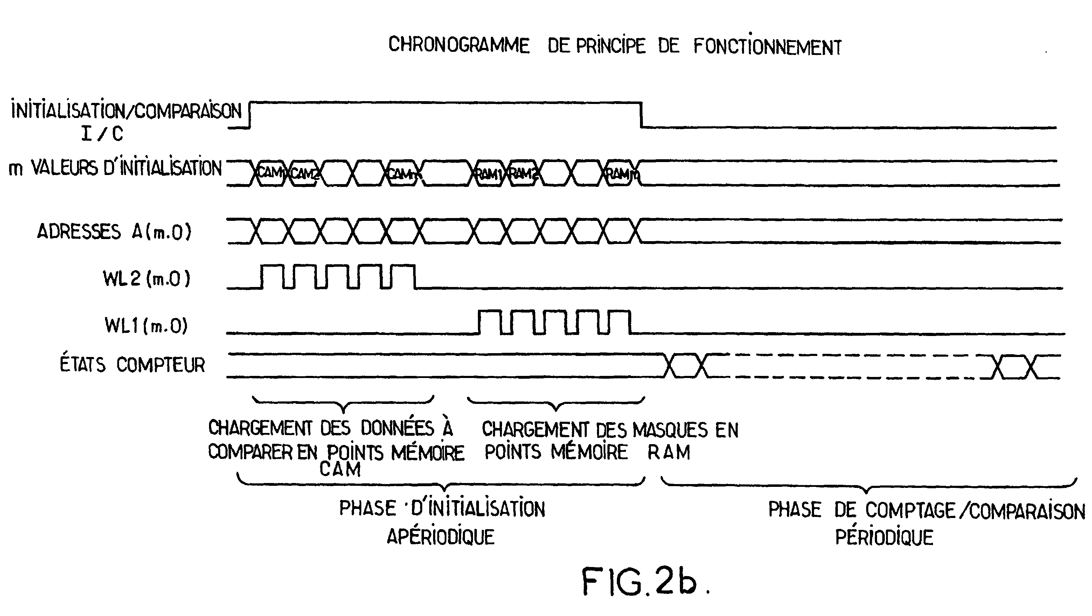

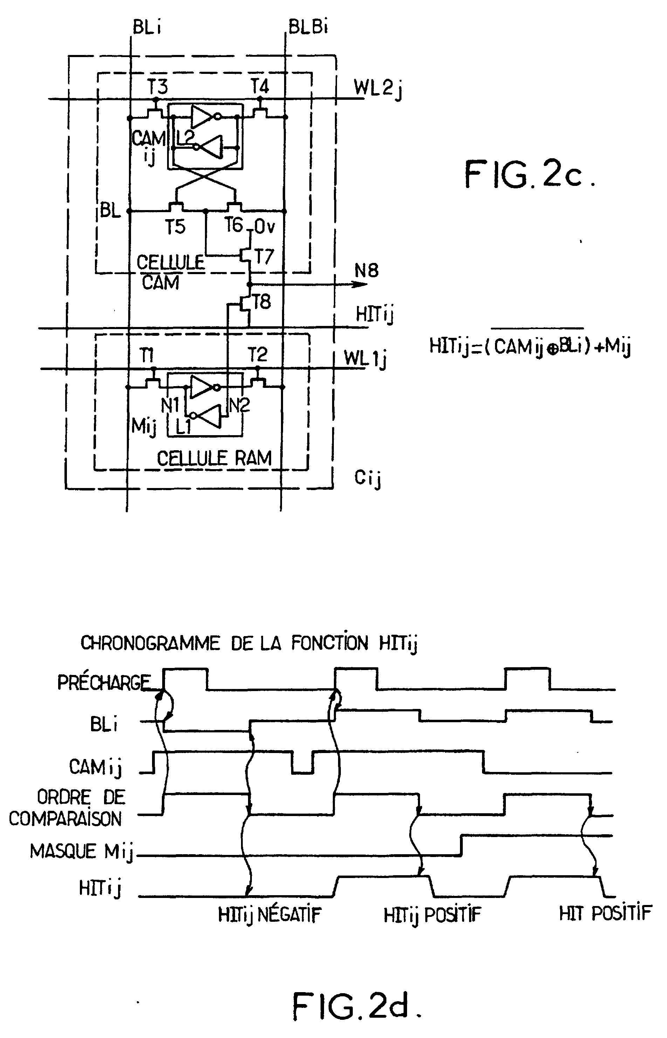

Une description plus détaillée d'un générateur d'impulsions électroniques programmables en durée et en fréquence, conforme à l'objet de la présente invention, sera maintenant donnée en liaison avec les figures 2a, 2b et 2c.

Le générateur d'impulsions électriques programmables en durée et en fréquence, objet de la présente invention, tel que représenté en figure 2a, comprend m sorties programmables distinctes, notées $S_j$, $j \in [0,m-1]$. Par sorties programmables distinctes, on indique que chaque sortie $S_j$ est susceptible d'engendrer périodiquement une forme d'onde distincte des formes d'ondes engendrées par les autres sorties. Chaque sortie $S_j$ est connectée à un port délivrant les formes d'ondes précitées, noté $PWM_j$.

Conformément à un aspect particulièrement remarquable du générateur d'impulsions, objet de la présente invention, celui-ci comprend, ainsi que représenté en figure 2a, au moins un circuit d'initialisation-base de temps, piloté par un signal d'horloge, noté CLK, ce signal d'horloge constituant un signal d'horloge de référence délivré par exemple par le système d'exploitation d'une unité informatique.

Le circuit d'initialisation-base de temps 1 est en outre piloté par un signal d'initialisation/comparaison, noté I/C, le signal I/C ayant pour objet essentiellement de commander le circuit d'initialisation-base de temps selon une phase dite d'initialisation du générateur d'impulsions électroniques programmables, suivie d'une phase de comparaison, c'est-à-dire d'une phase au cours de laquelle les formes d'ondes programmées sont engendrées par les sorties $S_j$ précédemment mentionnées, ainsi qu'il sera décrit ultérieurement dans la description.

Compte tenu du mode opératoire précité, on comprend que le signal d'initialisation/comparaison I/C peut être constitué par un simple signal logique binaire, pour lequel le phase d'initialisation est validée pour la valeur vraie de ce signal binaire, la phase de comparaison étant alors inhibée, alors qu'au contraire, cette phase de comparaison est validée pour la valeur complémentée de la valeur vraie de ce signal binaire, et réciproquement.

Par convention, on indique que le signal d'initialisation/comparaison I/C correspond ainsi à un signal d'initialisation présentant une valeur vraie et un signal dit de comparaison présentant également une valeur vraie. Les deux signaux, signal d'initialisation et signal de comparaison, présentent alors une valeur vraie pour les valeurs complémentées du signal logique précédemment cité.

Conformément à un aspect particulier du générateur d'impulsions, objet de la présente invention, on indique que le circuit d'initialisation base de temps 1 délivre au moins m valeurs d'initialisation codées sur n bits, pour la valeur vraie du signal d'initialisation, chaque bit de ces valeurs d'initialisation étant désigné par $CAM_{ij}$, avec $i \in [0,n-1]$. En outre, en fonction du type de marquage utilisé, des valeurs correspondantes d'initialisation sont mémorisées au niveau des cellules RAM correspondantes. Ainsi, pour une comparaison stricte, une valeur zéro est mémorisée dans la cellule RAM d'adresse i,j alors que pour un marquage effectif du bit d'adresse i,j correspondante une valeur 1 est mémorisée dans cette même cellule RAM au cours de cette initialisation. Le circuit d'initialisation-base de temps 1 délivre respectivement une valeur de comptage périodique, codée sur n bits pour la valeur vraie du signal de comparaison, chaque bit de la valeur de comptage étant désigné par $BL_i$.

Dans ce but, ainsi que représenté également sur la figure 2a, le circuit d'initialisation-base de temps piloté 1 comporte, dans un mode de réalisation préférentiel, un compteur-décompteur 10 recevant le signal d'horloge CLK, ce signal d'horloge délivrant la valeur de comptage périodique codée sur n bits de 0 à n-1. Le compteur-décompteur 10 joue en quelque sorte le rôle d'une base de temps dans la mesure où ce compteur-décompteur recevant le signal d'horloge, délivre la valeur de comptage précitée modulo n avec une remise à zéro systématique dès que la valeur de modulo est atteinte. Le fonctionnement du compteur-décompteur 10 est de type tout-à-fait classique et il n'est pas nécessaire de décrire ce fonctionnement de manière plus détaillée.

En outre, le circuit d'initialisation-base de temps 1 comporte un circuit multiplexeur 11 recevant m valeurs d'initialisation codées sur n bits, chaque bit étant dénoté $CAM_{ij}$. Ces valeurs d'initialisation comportent également les valeurs de bit mémorisées au niveau des cellules RAM correspondantes, et sont des valeurs programmées, spécifiques, ainsi qu'il sera décrit ultérieurement dans la description. Le circuit multiplexeur 11 reçoit également la succession des valeurs de comptage codées sur n bits délivrées par le compteur-décompteur 10, et il délivre les valeurs de bit correspondantes en fonction de l'état du signal d'initialisation/comparaison I/C, ainsi qu'il sera décrit ci-après dans la description.

Enfin, le circuit d'initialisation-base de temps piloté 1 comporte une pluralité 12 de n circuits amplificateurs-inverseurs. Chaque amplificateur-inverseur, noté $12_0$ à $12_{n-1}$, engendre une valeur de bit $BL_0$, $BL_i$ à $BL_{n-1}$ lorsque le signal d'initialisation/comparaison I/C correspond à la valeur vraie du signal de comparaison ou les bits de rang correspondant, notés par analogie $BL_i$, $i \in [0,n-1]$, des m valeurs d'initialisation lorsque le signal d'initialisation/comparaison I/C correspond au contraire à la valeur vraie du signal d'initialisation. Chaque amplificateur-inverseur $12_i$ délivre cette valeur de bit $BL_i$ ainsi que la valeur complémentée de cette valeur de bit, notée $BLB_i$.

Ainsi, le circuit d'initialisation-base de temps 1 délivre au moins les m valeurs d'initialisation codées sur n bits pour la valeur vraie du signal d'initialisation, respectivement une valeur de comptage périodique codée également sur n bits pour la valeur vraie du signal de comparaison, chaque bit de la valeur de comptage étant désigné par $BL_i$, ainsi que bien entendu les valeurs complémentées $BLB_i$ de ces valeurs de bit.

Ainsi que représenté en outre en figure 2a, le générateur d'impulsions électroniques, objet de la présente invention, comprend un module de décodage 2, module décodeur d'adresse, recevant une pluralité de valeurs d'adresse $X \in [0,m-1]$, ce module de décodage 2 délivrant sur des lignes de mots un bit d'adresse de commande en écriture, noté $WL_{1j}$, $WL_{2j}$. Le module décodeur d'adresse peut être réalisé à titre d'exemple non limitatif par une table de consultation recevant en entrée les valeurs d'adresse X et délivrant un bit d'adresse de commande en écriture sur les lignes de mots précitées.

Enfin, le générateur d'impulsions, objet de la présente invention, comprend une matrice de comparaison de bits, portant la référence 3, cette matrice comportant n x m cellules de comparaison arrangées en m lignes et n colonnes, ainsi que représenté en figure 2a. Chaque cellule de comparaison est notée $C_{ij}$ et comporte une cellule mémoire RAM et une cellule mémoire adressable par le contenu, dite cellule mémoire CAM.

Les cellules mémoire RAM et cellules mémoire CAM sont adressables en écriture sur les lignes de mots par un bit d'adresse de commande en écriture, $WL_{1j}$ et $WL_{2j}$ respectivement, précédemment mentionnés dans la description. Chaque cellule de comparaison $C_{ij}$ reçoit pour mémorisation le bit de rang i $BL_i$ de la valeur de comptage et chaque cellule de comparaison d'adresse ij permet, d'une part, de mémoriser, le bit correspondant $CAM_{ij}$ de la valeur d'initialisation pour la valeur vraie du signal d'initialisation, et, d'autre part, de délivrer une valeur correspondant à la valeur complémentée du produit OU exclusif de ce bit $CAM_{ij}$ de la valeur d'initialisation et du bit $BL_i$ de la valeur de comptage, cette valeur étant notée $\overline{CAM_{ij} \oplus BL_i}$.

En outre, chaque cellule mémoire RAM d'adresse i,j délivre une valeur de bit de masquage, notée $M_{ij}$, cette valeur de masquage étant mémorisée pour la valeur vraie du signal d'initialisation. Chaque cellule mémoire CAM et cellule mémoire RAM de même adresse i,j, constitutives donc de la cellule de comparaison $C_{ij}$ correspondante, sont couplées par une fonction logique de type OU pour former la cellule de comparaison $C_{ij}$ correspondante. Chaque cellule de comparaison $C_{ij}$ délivre ainsi une valeur résultante, notée :

$$HIT_{ij} = (\overline{CAM_{ij} \oplus BL_i}) + M_{ij}. \tag{1}$$

Enfin, ainsi qu'on l'observera sur la figure 2a, toutes les cellules de comparaison $C_{ij}$ d'une même ligne de rang j sont couplées par une fonction logique de type OU à la sortie correspondante $S_j$. Le générateur d'impulsions électroniques programmables en durée et en fréquence, objet de la présente invention, permet ainsi, grâce à l'architecture représentée en figure 2a, d'effectuer une comparaison entre un mot de n bits, valeur d'initialisation stockée dans les cellules mémoire CAM de chaque ligne de rang j pour la valeur vraie du signal d'initialisation, avec la valeur de comptage délivrée par le circuit d'initialisation-base de temps piloté 1 pour la valeur vraie du signal de comparaison, et d'engendrer ainsi sur chaque sortie $S_j$ une impulsion programmée vérifiant la relation :

$$HIT_j \ = \ \sum_{i=0}^{n-1} HIT_{ij} \ = \ \sum_{i=0}^{n-1} [(\overline{CAM_{ij} \oplus BL_i}) + M_{ij}] \tag{2}$$

selon un signal périodique dont la période est une période harmonique de la période de la valeur de comptage périodique du compteur décompteur 10.

D'une manière générale, on indique que le mode opératoire du générateur d'impulsions électroniques programmables en durée et en fréquence, objet de la présente invention, peut être schématisé selon les étapes ci-après :

- une étape de chargement des valeurs initiales à comparer, c'est-à-dire des m valeurs initiales dans les cellules mémoire CAM d'adresse i,j, et,
- une étape de chargement des valeurs de masquage $M_{ij}$ en cellules mémoire RAM d'adresse i,j correspondantes, ces valeurs permettant en fait de forcer la comparaison à la valeur vraie quel que soit le résultat de la comparaison entre la valeur chargée dans une cellule mémoire CAM d'adresse i,j et la valeur du bit de rang i correspondant $BL_i$ transitant à un instant donné par la période d'horloge et délivré par le compteur-décompteur 10 pour valeur de comptage à cet instant.

On indique qu'il n'y a pas d'ordre spécifique de chargement à respecter, le chargement des cellules mémoire CAM d'adresse i,j et celui des cellules mémoire RAM d'adresse i,j correspondantes pouvant être effectués indifféremment l'un après l'autre.

Le mode opératoire du générateur d'impulsions électroniques programmables, objet de la présente invention, tel que représenté en figure 2a, est illustré en référence à la figure 2b, ainsi que mentionné précédemment, pour l'étape ou phase d'initialisation en fonctionnement apériodique, respectivement pour l'étape ou phase de comptage ou comparaison en fonctionnement périodique.

Une description plus détaillée de chaque cellule mémoire RAM et mémoire CAM constitutive d'une cellule de comparaison $C_{ij}$ sera maintenant donnée en liaison avec la figure 2c.

Ainsi que représenté sur la figure précitée, on indique que chaque cellule mémoire RAM comprend au moins un premier et deuxième transistor de type MOS, notés $T_1$ et $T_2$, dont l'électrode de grille est connectée en parallèle à la ligne de mot $WL_{1j}$. L'électrode de source du premier transistor $T_1$ et l'électrode de drain du deuxième transistor $T_2$ reçoit la valeur de bit $BL_i$ de la valeur de comptage, respectivement la valeur de bit complémentée $BLB_i$ de cette valeur de comptage. L'électrode de drain du transistor $T_1$ et l'électrode de source du transistor $T_2$ sont reliées par l'intermédiaire de deux inverseurs connectés en tête-bêche, le point commun entre les deux inverseurs précités et l'électrode de source du deuxième transistor MOS $T_2$ délivrant la valeur mémorisée ou valeur de masquage $M_{ij}$.

De même que représenté sur la figure 2c, chaque cellule mémoire CAM comprend au moins un premier et un deuxième transistor MOS, notés $T_3$, $T_4$, dont l'électrode de grille est connectée en parallèle à la ligne de mot $WL_{2j}$ et dont l'électrode de source, respectivement de drain, reçoit la valeur de bit $BL_i$, respectivement la valeur de bit complémentée $BLB_i$, de la valeur de comptage délivrée par le compteur-décompteur 10. L'électrode de drain, respectivement de source, des premier et deuxième transistors $T_3$, $T_4$, est reliée par l'intermédiaire de deux inverseurs connectés en tête-bêche de façon semblable à la structure de la mémoire RAM précédemment décrite en liaison avec la figure 2c.

En outre, un troisième, $T_5$, et un quatrième transistor MOS, $T_6$, sont connectés en cascade par l'intermédiaire d'un point commun entre leur électrode de drain et électrode de source. L'électrode de source du troisième transistor MOS $T_5$ reçoit la valeur de bit $BL_i$ et l'électrode de drain du quatrième transistor MOS $T_6$ reçoit la valeur de bit complémentée $BLB_i$ de la valeur de comptage délivrée par le compteur-décompteur 10. Les électrodes de grille du troisième $T_5$ et du quatrième $T_6$ transistor MOS sont connectées à l'électrode de source du deuxième $T_4$, respectivement à l'électrode de drain du premier $T_3$ transistor MOS.

Enfin, un cinquième transistor MOS, $T_7$, est prévu, l'électrode de source de ce cinquième transistor étant connectée à la tension de référence, tension de masse à O volt du dispositif par exemple, alors que l'électrode de grille du cinquième transistor $T_7$ est connectée au point commun du troisième et du quatrième transistor MOS $T_5$, $T_6$. L'électrode de drain du cinquième transistor MOS $T_7$ délivre la valeur complémentée du produit OU exclusif entre les valeurs mémorisées par la cellule mémoire CAM, valeurs mémorisées $CAM_{ij}$ et $BL_i$.

Enfin, ainsi que représenté en figure 2c, le couplage de type OU entre cellules mémoire CAM et RAM de même adresse i,j est réalisé par l'intermédiaire d'un transistor MOS $T_8$, transistor de couplage dont l'électrode de source est reliée à l'électrode de drain du cinquième transistor MOS $T_7$ et reçoit la valeur complémentée du produit OU exclusif entre les valeurs mémorisées $CAM_{ij}$ et $BL_i$. L'électrode de grille du transistor $T_8$ de couplage est connectée au point commun entre le deuxième transistor MOS $T_2$ et les inverseurs tête-bêche de la cellule mémoire RAM de même adresse i,j. L'électrode de drain du transistor de couplage $T_8$ délivre la valeur résultante selon la relation (1) mentionnée précédemment dans la description.

Enfin, on indique que le couplage par une fonction logique de type OU de toutes les cellules de comparaison $C_{ij}$ d'une même ligne de rang j est effectué par exemple par l'interconnexion en parallèle de toutes les électrodes de drain des transistors MOS $T_8$ de couplage à une ligne de sortie connectée à la sortie $S_j$ de rang j correspondant.

Le fonctionnement de chaque cellule RAM et CAM d'adresse i,j est le suivant :

Lorsque la ligne de mot $WL_{1j}$ est portée au niveau haut, pour commande en écriture, les transistors MOS $T_1$ et $T_2$, de type N par exemple, sont rendus conducteurs. Si, à titre d'exemple, au même instant, on suppose qu'un signal de niveau haut est appliqué sur la ligne de bit $BL_i$ et qu'en conséquence un niveau bas est appliqué sur la ligne de bit du bit de valeur complémenté $BLB_i$, le potentiel de la ligne de bit à la valeur $BL_i$ est appliqué au noeud $N_1$ des inverseurs en tête-bêche $L_1$ de la cellule RAM, ces inverseurs en tête-bêche constituant en fait un circuit de verrouillage ou "*latch*" en vocable anglo-saxon, par l'intermédiaire du transistor $T_1$, tandis que le potentiel correspondant à la valeur complémentée $BLB_i$ est appliqué au noeud $N_2$ du circuit de verrouillage $L_1$ par l'intermédiaire du transistor $T_2$. Dans ces conditions, on considère que le circuit de verrouillage $L_1$ a stocké une valeur au niveau 1. Cette valeur correspond à la valeur de masquage $M_{ij}$ de l'adresse i,j correspondante.

Dans les mêmes conditions, lorsque la ligne de mot $WL_{1j}$ est portée au niveau haut alors que la ligne de bit pour la valeur $BL_i$ est au niveau bas, la valeur complémentée $BLB_i$ étant par contre portée au niveau haut, on considère que le circuit de verrouillage $L_1$ a au contraire stocké un niveau bas, dit niveau O.

Par suite, lorsque le circuit de verrouillage $L_1$ est réputé avoir stocké une valeur 1, on comprend que le noeud $N_1$ est au potentiel haut et que le noeud $N_2$ est au potentiel bas, et réciproquement, le circuit de verrouillage $L_1$ est réputé avoir stocké une valeur 0, ou valeur basse, lorsque le noeud $N_1$ est au potentiel bas et le noeud $N_2$ au potentiel haut.

En ce qui concerne le fonctionnement de chaque cellule mémoire CAM, celui-ci peut être illustré de la façon ci-après.

Chaque cellule CAM comprend en fait la même structure que la cellule RAM de même adresse, à l'exception des transistors $T_5$, $T_6$ et $T_7$. Le fonctionnement en mode stockage de chaque cellule mémoire CAM est donc identique à celui de chaque cellule mémoire RAM lorsque la ligne de mot $WL_{2j}$ de commande en écriture est portée au potentiel haut, la valeur de bit $BL_i$ de la valeur de comptage étant portée au potentiel haut ou bas et la valeur complémentée $BLB_i$ correspondante à la valeur complémentée correspondante.

En supposant, à titre d'exemple illustratif, que le circuit de verrouillage $L_2$ de la cellule mémoire CAM ait préalablement mémorisé une valeur 1, lorsqu'on applique un niveau bas $BL_i$ et en conséquence un niveau haut $BLB_i$, le transistor $T_5$ de type NMOS reste bloqué, tandis que le transistor $T_6$ de même type devient conducteur, appliquant ainsi un potentiel de niveau haut sur la grille du transistor $T_7$ de type NMOS, le noeud $N_8$ représenté sur la figure 2c étant ainsi porté à un potentiel bas.

De même si, à titre d'exemple, on suppose que le circuit de verrouillage $L_2$ de la cellule mémoire CAM a préalablement stocké une valeur 0, potentiel bas, et que l'on applique une valeur de bit correspondant à un potentiel haut $BL_i$ et donc une valeur de bit complémentée $BLB_i$ correspondant à un potentiel bas, la grille du transistor $T_5$ de type NMOS est portée à un niveau haut, rendant ce transistor conducteur, et le noeud $N_8$ de la figure 2c est porté à un potentiel bas par l'intermédiaire du transistor $T_7$ qui est conducteur.

Les autres cas correspondent successivement à :

- circuit de verrouillage $L_2$ de la cellule mémoire CAM à la valeur 1, $BL_i$ au niveau haut, $BLB_i$ niveau bas ;
- circuit de verrouillage de la cellule mémoire CAM à la valeur 0, $BL_i$ au niveau bas, $BLB_i$ au niveau haut.

Le noeud $N_8$ reste à un niveau haut si, par exemple, il a été placé à un tel niveau par un élément de précharge représenté sur la figure 2a pour chaque cellule mémoire CAM correspondante.

Le fonctionnement de l'ensemble est représenté par le tableau 1 ci-après, la valeur $BLB_i$ désignant toujours la valeur complémentée de $BL_i$.

Tableau 1

| CAM$_{ij}$ | BL$_i$ | N8 |
|:---:|:---:|:---:|
| 0 | 0 | 1 |
| 0 | 1 | 0 |
| 1 | 0 | 0 |
| 1 | 1 | 1 |

Ce mode opératoire permet de réaliser une fonction identité NON/OU exclusif au noeud $N_8$ de chaque cellule de comparaison $C_{ij}$ vérifiant la relation logique :

$$N_8 = \overline{CAM_{ij} \oplus BL_i}. \tag{3}$$

La commande de la grille de chaque transistor $T_8$ par la cellule RAM correspondante permet alors d'obtenir la relation logique (2) précédemment mentionnée dans la description.

Le chronogramme de la valeur résultante à partir d'un signal de précharge délivré à chaque cellule de mémoire RAM et CAM par un circuit de précharge de type classique, tel que représenté en figure 2a, est donné en figure 2d pour la cellule de comparaison $C_{ij}$. Les circuits d précharge ne sont pas décrits en raison de leur type classique connu de l'homme de l'art.

La multiplication sur une ligne pour n bits constitutifs des valeurs de comptage, par exemple pour n = 16, permet d'effectuer une comparaison entre un mot de 16 bits stocké dans les cellules mémoire CAM de la ligne considéré et un mot d'un nombre correspondant, n = 16 par exemple, de bits correspondant à la valeur de comptage, c'est-à-dire aux valeurs $BL_i$ et $BLB_i$ précédemment mentionnées dans la description, l'état de repos étant matérialisé par $BL_i$ = $BLB_i$, tous les résultats de comparaison délivrés par les cellules de comparaison d'une même ligne étant reliés par la liaison logique OU précédemment mentionnée dans la description.

Dans ces conditions, la sortie $S_j$ correspondante, pour la ligne de rang j considérée, vérifie la relation (3) précédemment mentionnée dans la description.

Dans cette relation, lorsque tous les bits de masquage $M_{ij}$ sont stockés inactifs, la relation précédente est à la valeur vraie si et seulement si toutes les comparaisons sont identiques, ce qui implique $CAM_{ij}$ = $BL_i$.

Si, au contraire, tous les bits de masquage $M_{ij}$ sont stockés actifs, la relation précédente est à la valeur vraie quel que soit le contenu du mot correspondant à la valeur de comptage, c'est-à-dire aux valeurs correspondantes des bits $BL_i$ et valeur complémentée $BLB_i$.

Ainsi, lorsque le mot à comparer, c'est-à-dire la valeur de comptage instantanée délivrée par le compteur-décompteur 10 diffère de un ou plusieurs bits par rapport au mot stocké sur une même ligne de rang j de cellule mémoire CAM, la relation précédente est à la valeur vraie lorsque les valeurs de masquage correspondantes sont à la valeur active.

Un exemple de valeur vraie des comparaisons délivrées par chaque cellule de comparaison $C_{ij}$ est donné dans le tableau 2 ci-après :

Tableau 2

| $CAM_{ij}$ | 1 | 0 | 0 | 1 | 0 | 0 | 1 | 1 | 0 | 0 | 0 | 1 | 0 | 1 | 1 | 1 |
|---|---|---|---|---|---|---|---|---|---|---|---|---|---|---|---|---|
| $BL_i$ | 1 | 0 | 0 | 0 | 1 | 0 | 1 | 1 | 1 | 0 | 0 | 1 | 1 | 0 | 1 | 1 |
| $M_{ij}$ | 0 | 0 | 1 | 1 | 1 | 0 | 0 | 1 | 1 | 0 | 0 | 0 | 1 | 1 | 0 | 0 |

Bien entendu, une pluralité de mots de comparaison, c'est-à-dire les m valeurs initiales, peut ainsi être prévue, chaque mot étant mémorisé au niveau d'une ligne de cellules mémoire de type CAM, le générateur d'impulsions électroniques programmables en durée et en fréquence, objet de la présente invention, présentant alors la configuration en matrice de cellules de comparaison telle que représentée en figure 2a.

On comprend ainsi que le générateur d'impulsions électroniques, objet de la présente invention, permet de programmer, chaque ligne de rang j de cellules de comparaison $C_{ij}$, de façon à faire varier le nombre et la largeur des impulsions dans une période donnée par la période de récurrence du compteur-décompteur 10, selon le mode opératoire qui sera explicité ci-après dans la description.

A l'aide de la structure représentée en figure 2a, on peut ainsi réaliser un générateur d'impulsions électroniques programmables en durée et en fréquence à m sorties, chaque sortie $S_j$ pouvant en fait être considérée comme un générateur distinct $PWM_j$.

A chaque front du signal d'horloge CLK délivré par l'horloge système par exemple, le compteur-décompteur 10 du circuit d'initialisation-base de temps piloté 1 est incrémenté et l'on effectue ainsi une comparaison entre la sortie du compteur-décompteur, c'est-à-dire la valeur instantanée de comptage et le contenu de la matrice de points, c'est-à-dire chaque ligne de cellules mémoire CAM et cellules mémoire RAM.

La période des impulsions délivrées est le modulo du compteur, c'est-à-dire une période harmonique de la période de la valeur de comptage périodique. On comprend bien entendu qu'en fonction des valeurs programmées, notamment des bits de masquage $M_{ij}$ et des valeurs d'initialisation, la période des impulsions peut être, soit égale à la période de comptage du compteur-décompteur, soit au contraire une période harmonique de ce dernier, ainsi qu'il sera décrit ci-après.

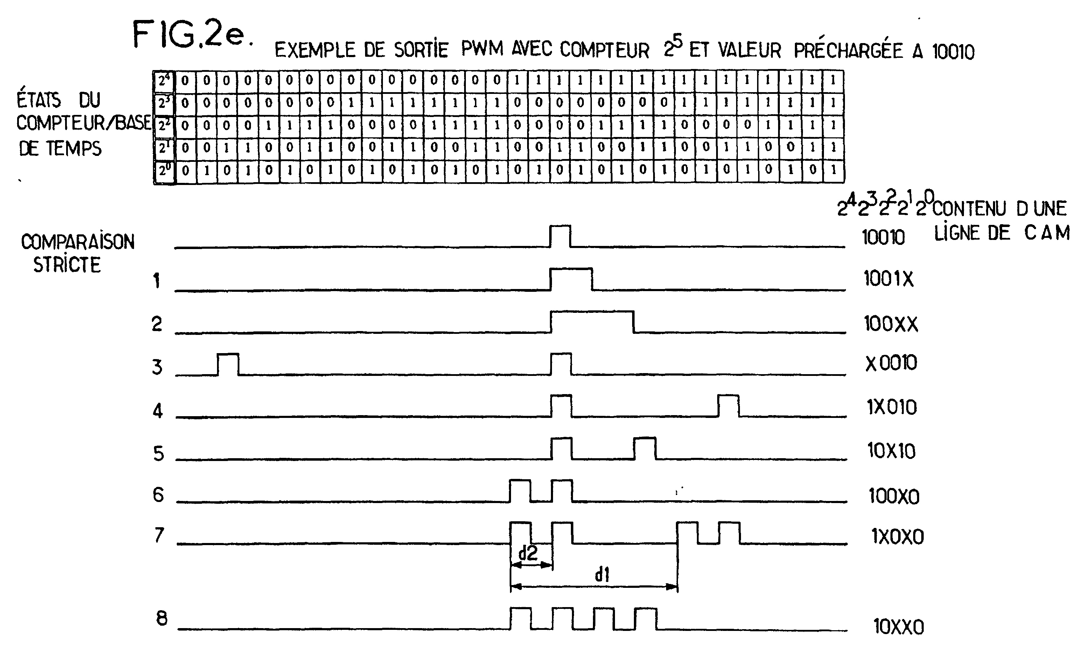

Les différentes formes d'ondes à durée variable et à impulsions multiples seront décrites en liaison avec la figure 2e dans un exemple non limitatif de mise en oeuvre utilisant un compteur-décompteur de valeur $2^5$ pour une valeur préchargée, c'est-à-dire une valeur d'initialisation correspondant à une ligne de rang j par exemple, cette valeur préchargée étant arbitrairement prise égale à la valeur 10010.

Sur la figure 2e, on a représenté, d'une part, les états du compteur-décompteur 10, c'est-à-dire la valeur de comptage et finalement la valeur des bits de poids $2^0$ à $2^4$, ainsi que les valeurs correspondantes contenues dans une ligne de rang j de cellules mémoire CAM correspondantes.

En liaison avec la figure 2e, on indique que pour la valeur d'initialisation 10010 chargée en mémoire CAM, lorsque la valeur de comptage par le compteur-décompteur atteint cette valeur, c'est-à-dire lors de la comparaison ou identité stricte représentée en figure 2e entre la valeur de comptage et la valeur d'initialisation, on obtient une impulsion unique par période de comptage du compteur-décompteur dont la durée est égale à un cycle d'horloge CLK.

Si au contraire on masque le bit de poids faible, bit de poids $2^0$, la valeur $M_{0j}$ étant portée à la valeur X, la valeur X désignant ici indifféremment la valeur 0 ou 1, la relation (2) précédente est vraie deux fois consécutives, ce qui permet d'engendrer une impulsion dont la durée est égale à deux cycles d'horloge, ainsi que représenté sur la forme d'ondes 1 de la figure 2e.

Si, en outre, on masque le bit de poids $2^1$, la valeur d'initialisation étant portée à la valeur 100XX, la relation (2) devient vraie quatre fois consécutivement, ainsi que représenté au point 2 de la figure 2e, et ainsi de suite. On peut ainsi faire varier la durée d'une impulsion par puissance de deux fois la durée de la période ou du cycle d'horloge système dans l'intervalle d'une période de comptage du compteur-décompteur en masquant consécutivement les bits de poids faible vers les bits de poids fort. La durée D de l'impulsion engendrée vérifie ainsi la relation :

$$D = 2^{k+1} \tag{4}$$

où k représente le poids du bit de rang le plus élevé des bits masqués.

Les formes d'ondes correspondantes sont données aux positions 1 et 2 de la figure 2e.

En ce qui concerne la programmation par impulsions multiples, celle-ci peut être obtenue en démasquant le bit de poids le plus faible, bit de poids $2^0$ pour l'obtention d'une comparaison stricte entre la valeur correspondante mémorisée en mémoire CAM et la valeur $BL_i$, et qu'en outre, on masque un bit parmi les n-1 bits restants. L'on engendre alors deux impulsions dont la durée est égale à une durée de cycle d'horloge système CLK.

La distance, exprimée en nombre de périodes d'horloge CLK entre ces deux impulsions, est fonction du poids du bit masqué.

Ainsi, le nombre d'impulsions obtenu est une puissance de 2 du nombre de bits masqués, alors que la distance entre les impulsions est donnée par la relation :

$$d = 2^p \tag{5}$$

où p représente le poids du bit masqué.

Les formes d'ondes représentées aux points 3, 4, 5 et 6 de la figure 2e permettent de vérifier le résultat précédemment indiqué.

Le générateur d'impulsions électroniques programmables en durée et en fréquence, objet de la présente invention, permet bien entendu de programmer toutes formes d'ondes avec une récurrence, c'est-à-dire une distance entre impulsions fonction du rang du bit masqué et un nombre d'impulsions fonction du nombre de bits masqués.

Ainsi, si l'on considère une suite $2^r$, $2^s$ et $2^t$ où r, s et t représentent le rang des bits masqués, un motif périodique tel que représenté en positions 7 et 8 de la figure 2e peut être obtenu avec les paramètres ci-après :

- distance $d_1 = 2^r$, où r représente le rang du bit de poids le plus fort des bits masqués ;
- distance $d_2 = 2^s$, où s représente le rang du bit de poids le plus faible des bits masqués ;
- $d_1$ représente la distance entre motifs constitués par deux impulsions élémentaires, alors que $d_2$ représente la distance entre impulsions élémentaires constitutives d'un motif ;
- le nombre de motifs constitués par des impulsions élémentaires est donné par $N = 2^t$ où t représente le nombre de bits masqués.

Dans le cadre de la figure 2e, on indique que les formes d'ondes représentées aux positions 1 et 2 ne sont en fait qu'un cas particulier dans lequel la distance $d_1$ est égale à 1, soit, pour r = 0, alors que la distance $d_2$ est égale au nombre, soit $2^s = 2^t$.

En ce qui concerne les formes d'ondes représentées aux positions 3, 4, 5 et 6, celles-ci constituent un cas particulier pour lequel r = s.

Le mode de réalisation du circuit générateur d'impulsions électroniques programmables en durée et en fréquence, objet de la présente invention, précédemment décrit en liaison notamment avec les figures 2a et suivantes, apparaît particulièrement intéressant dans la mesure où celui-ci permet d'engendrer des trains d'impulsions constitués de motifs à impulsions multiples, ce qui permet d'augmenter considérablement la flexibilité d'utilisation de ce type de générateur par rapport aux systèmes décrits dans l'art antérieur.

Toutefois, on notera que dans le mode de réalisation précité, les distances et le nombre d'impulsions sont des puissances entières de 2. Une telle limitation ne permet pas un réglage aussi fin que la période ou cycle d'horloge système, ce qui, dans certains cas, peut constituer un inconvénient.

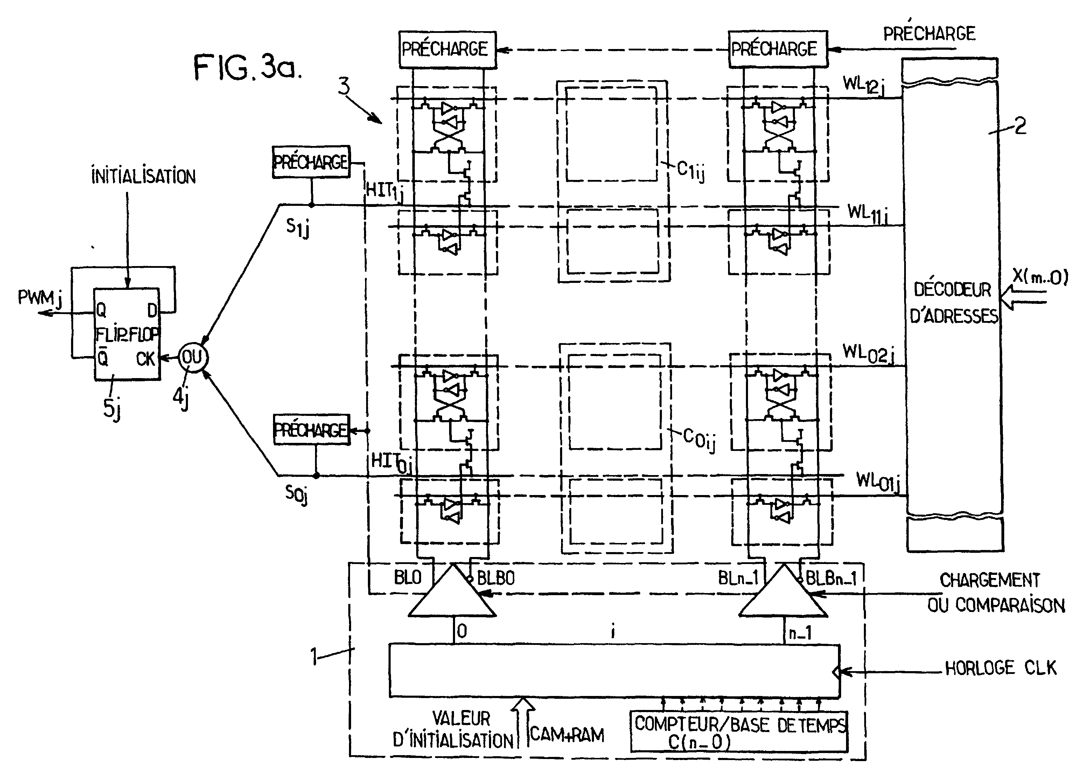

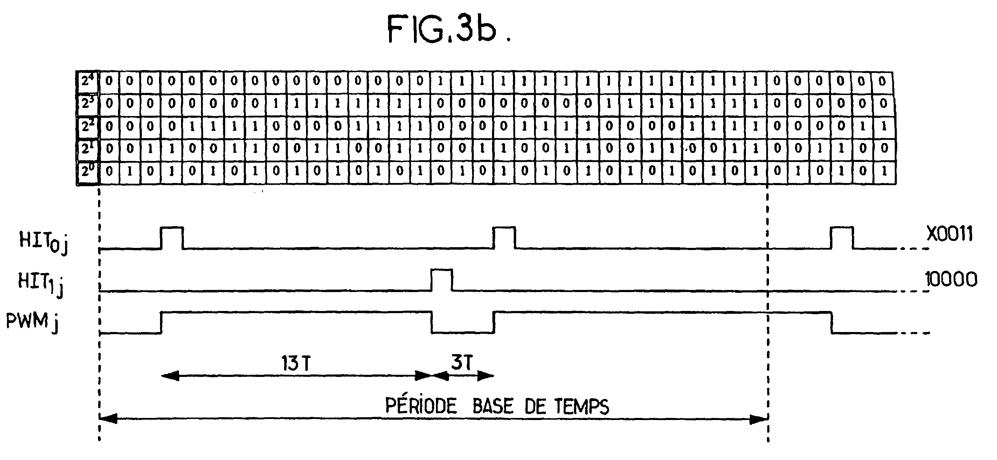

Afin de remédier à l'inconvénient précité, un mode de réalisation préférentiel du générateur d'impulsions électroniques programmables en durée et en fréquence, objet de la présente invention, sera décrit en liaison avec les figures 3a et 3b.

Selon le mode de réalisation précité représenté en figure 3a, chaque ligne de cellules de comparaison de rang j est dédoublée en une première et une deuxième ligne élémentaire de cellules de comparaison, chaque cellule de comparaison portant la référence $C_{0ij}$, respectivement $C_{1ij}$, le premier indice 0 ou 1 désignant l'indice de dédoublement de chaque cellule de comparaison pour former la première et la deuxième ligne élémentaire de cellules de comparaison. On comprend, ainsi que représenté sur la figure 3a, que les cellules de comparaison sont alignées pour former la première et la deuxième ligne élémentaire, chaque ligne élémentaire étant interconnectée à une sortie correspondante $S_{0j}$, respectivement $S_{1j}$, le premier indice désignant l'indice de dédoublement.

Selon un aspect particulièrement avantageux du générateur d'impulsions électroniques programmables, objet de la présente invention, tel que représenté dans le mode de réalisation de la figure 3a, chaque ligne élémentaire de cellules de comparaison, c'est-à-dire les lignes désignées par $S_{0j}$ et $S_{1j}$, sont programmables indépendamment et complémentairement l'une de l'autre, de façon à délivrer des motifs de trains d'impulsions complémentaires.

Par lignes élémentaires de cellules de comparaison programmables indépendamment et complémentairement l'une de l'autre, on entend que chaque ligne élémentaire de cellule peut être programmée indépendamment, c'est-à-dire compte non tenu de la programmation de l'autre ligne élémentaire de cellules de comparaison. Le caractère complémentaire de la programmation réside dans le fait que la programmation à l'identique de l'une et l'autre des lignes élémentaires de cellules n'offre pas d'intérêt effectif et que, conformément à l'objet de la présente invention, il est avantageux de programmer l'une et l'autre des lignes élémentaires de cellules de comparaison $S_{0j}$ et $S_{1j}$ de manière que les motifs engendrés soient distincts, afin de permettre la superposition de ces motifs pour créer un motif ou train d'impulsions spécifique, beaucoup plus fin, ainsi qu'il sera décrit ci-après dans la description.

Ainsi qu'on l'observera en figure 3a, on indique que le générateur comporte en outre, pour chaque couple de première et deuxième ligne élémentaire $S_{0j}$ et $S_{1j}$ tel que représenté en figure 3a, un circuit logique de type OU interconnecté aux première et deuxième sorties élémentaires $S_{0j}$ et $S_{1j}$, ce circuit logique de type OU délivrant un signal de superposition des motifs ou de train d'impulsions complémentaires programmés sur chaque ligne élémentaire de cellule de comparaison.

Le circuit logique de type OU, portant la référence $4_j$ sur la figure 3a, permet ainsi d'assurer la superposition des motifs de train d'impulsions complémentaires programmés sur les lignes élémentaires $S_{0j}$ et $S_{1j}$.

Toutefois, ainsi que représenté également sur la figure 3a, le circuit logique de type OU $4_j$ peut être suivi d'un circuit référencé $5_j$, de type bistable par exemple, recevant le signal de superposition et délivrant un signal résultant dont la résolution temporelle est égale à celle de la période du signal d'horloge de référence.

Le mode de réalisation décrit en figure 3a permet en fait de régler les impulsions ou les trains d'impulsions à la durée souhaitée avec une précision correspondant à la durée de la période ou cycle de l'horloge système CLK.

Sur la figure 3b, on a représenté à titre d'exemple non limitatif les chronogrammes d'impulsions obtenues lors de la mise en oeuvre d'un générateur d'impulsions électroniques programmables en durée et en fréquence dans lequel une ligne de rang j de cellules de comparaison est constituée par deux lignes élémentaires, une première ligne élémentaire étant programmée de façon à délivrer un signal représenté par $HIT_{0j}$ pour une valeur initiale comportant 5 bits, le bit de poids le plus fort étant masqué à la valeur X, les deux bits suivants étant à la valeur 0, et les deux derniers bits à la valeur 1, alors que la deuxième ligne élémentaire est programmée de façon à délivrer un signal $HIT_{1j}$ pour une valeur initiale codée sur 5 bits dont le bit de poids le plus fort est égal à la valeur 1 et les quatre autres bits successifs égaux à la valeur 0.

On comprend que dans ce cas, les signaux $HIT_{0j}$ et $HIT_{1j}$ sont appliqués à l'entrée de la porte OU référencée $4_j$, ce qui permet de piloter le circuit bascule $5_j$ de façon à délivrer le signal résultant $PWM_j$ tel que représenté en figure 3b, constitué par une série d'impulsions de durée 3T où T représente le cycle d'horloge système CLK séparées par 13 périodes ou cycles d'horloge T.

On indique bien entendu que le principe d'impulsions multiples peut être appliqué de manière à obtenir, par le biais d'une bascule ou, le cas échéant, en l'absence de bascule $5_j$, des formes d'ondes de récurrence souhaitée.

On a ainsi décrit un générateur d'impulsions électroniques programmables en durée et en fréquence particulièrement performant dans la mesure où, grâce à une mise en oeuvre particulièrement souple de chaque ligne de cellules de comparaison; il est possible d'obtenir, sur chacune de celles-ci, une pluralité d'impulsions configurées en trains d'impulsions ou motifs dont la résolution temporelle est au plus égale à celle de la période ou cycle du signal d'horloge système CLK.

Ce type de générateur d'impulsions électroniques apparaît particulièrement satisfaisant dans la mesure où il est possible d'envisager des applications très variées telles que générateurs de signaux périodiques de périodes diverses de phénomènes physiologiques, tels que pulsations cardiaques ou autres, ou, par exemple, générateurs d'impulsions électroniques programmables en durée et en fréquence sous forme de circuits dédiés destinés à la reconnaissance de signature fréquentielle de sources d'émission.

**Revendications**

1. Générateur d'impulsions électroniques programmables en durée et en fréquence comprenant m sorties programmables distinctes, $S_j$, $j \in [0,m-1]$, **caractérisé en ce qu'**il comporte au moins :

   - un circuit d'initialisation-base de temps (1) piloté par un signal d'horloge de référence (CLK) et par un signal d'initialisation/comparaison, ledit circuit d'initialisation-base de temps délivrant au moins m valeurs d'initialisation codées sur n bits pour la valeur vraie du signal d'initialisation, chaque bit desdites valeurs d'initialisation étant désigné par $CAM_{ij}$, $i \in [0,n-1]$, respectivement une valeur de comptage périodique codée sur n bits, pour la valeur vraie du signal de comparaison, chaque bit de la valeur de comptage étant désigné par $BL_i$ ;
   - des moyens de décodage (2) recevant une pluralité de valeurs d'adresse $X \in [0,m-1]$ et délivrant sur des lignes de mot un bit d'adresse de commande en écriture $WL_{1j}$, $WL_{2j}$ ;
   - une matrice de comparaison de bits comportant n x m cellules de comparaison ($C_{00} ... C_{n-1,m}$) arrangées en m lignes et n colonnes, chaque cellule de comparaison $C_{ij}$ comportant une cellule mémoire RAM et une cellule mémoire CAM, cellule mémoire adressable par le contenu, lesdites cellules mémoire étant adressables en écriture sur lesdites lignes de mot par un bit d'adresse de commande en écriture $WL_{1j}$ et $WL_{2j}$ respectivement, et recevant chacune pour mémorisation le bit de rang i $BL_i$ de ladite valeur de comptage, chaque cellule de comparaison d'adresse i,j permettant, d'une part, de mémoriser ledit bit correspondant $CAM_{ij}$ de la valeur d'initialisation pour la valeur vraie du signal d'initialisation, et, d'autre part, de délivrer pour la valeur vraie du signal de comparaison une valeur $\overline{CAM_{ij} \oplus BL_i}$, valeur complémentée du produit OU exclusif de ce bit $CAM_{ij}$ de la valeur d'initialisation et du bit $BL_i$ de ladite valeur de comptage, chaque cellule mémoire RAM d'adresse i,j délivrant une valeur de bit de masquage mémorisée pour la valeur vraie du signal d'initialisation, désignée par $M_{ij}$, et chaque cellule mémoire CAM et RAM de même adresse i,j étant couplées par un couplage logique de type OU pour former ladite cellule de comparaison $C_{ij}$ et chaque cellule de comparaison délivrant une valeur résultante

$$HIT_{ij} = (\overline{CAM_{ij} \oplus BL_i}) + M_{ij},$$

   toutes les cellules de comparaison $C_{ij}$ d'une même ligne de rang j étant couplées par une fonction logique de type OU à la sortie correspondante $S_j$, ce qui permet d'effectuer une comparaison entre un mot de n bits valeur d'initialisation stocké dans les cellules mémoire CAM de chaque ligne de rang j pour la valeur vraie du signal d'initialisation avec la valeur de comptage délivrée par le circuit d'initialisation-base de temps piloté pour la valeur vraie du signal de comparaison et d'engendrer ainsi sur chaque sortie $S_j$ une impulsion programmée vérifiant la relation :

$$HIT_j = \sum_{i=0}^{n-1} HIT_{ij} = \sum_{i=0}^{n-1} [(\overline{CAM_{ij} \oplus BL_i}) + M_{ij}]$$

   selon un signal périodique dont la période est une période harmonique de la période de la valeur de comptage périodique.

2. Générateur selon la revendication 1, **caractérisé en ce que** ledit circuit d'initialisation-base de temps piloté comporte :

   - un compteur-décompteur (10) recevant ledit signal d'horloge et délivrant ladite valeur de comptage périodique codée sur n bits ;
   - un circuit multiplexeur (11) recevant, d'une part, lesdites m valeurs d'initialisation codées sur n bits $CAM_{ij}$, et, d'autre part, la valeur de comptage codée sur n bits $BL_i$, délivrée par le compteur-décompteur, ledit circuit multiplexeur délivrant les valeurs de bit correspondantes ;
- une pluralité de n circuits amplificateurs inverseurs ($12_0$ ... $12_{n-1}$), recevant chacun une valeur de bit et délivrant cette valeur de bit et la valeur complémentée de cette valeur de bit $BLB_i$.

**3.** Générateur selon l'une des revendications 1 ou 2, **caractérisé en ce que** chaque cellule mémoire de type RAM comprend au moins un premier et un deuxième transistor MOS ($T_1$, $T_2$) dont l'électrode de grille est connectée en parallèle à ladite ligne de mot $WL_{1j}$ et dont l'électrode de source, respectivement de drain, reçoit la valeur de bit $BL_i$, respectivement la valeur de bit complémentée $BLB_i$, et dont l'électrode de drain, respectivement de source, est reliée par l'intermédiaire de deux inverseurs connectés en tête-bêche, le point commun entre les deux inverseurs et l'électrode de source du deuxième transistor MOS délivrant la valeur mémorisée $M_{ij}$.

**4.** Générateur selon l'une des revendications 1 à 3, **caractérisé en ce que** ladite cellule mémoire CAM comprend au moins :

- un premier et un deuxième transistor MOS ($T_3$, $T_4$) dont l'électrode de grille est connectée en parallèle à ladite ligne de mot $WL_{2j}$ et dont l'électrode de source, respectivement de drain, reçoit la valeur de bit $BL_i$, respectivement la valeur de bit complémentée $BLB_i$, et dont l'électrode de drain, respectivement de source, est reliée par l'intermédiaire de deux inverseurs connectés en tête-bêche ;
- un troisième et un quatrième transistor MOS ($T_5$, $T_6$) connectés en cascade par l'intermédiaire d'un point commun entre leur électrode de drain et électrode de source, l'électrode de source du troisième transistor MOS ($T_5$) recevant la valeur de bit $BL_i$ et l'électrode de drain du quatrième transistor MOS ($T_6$) recevant la valeur de bit complémentée $BLB_i$, les électrodes de grille du troisième ($T_5$) et du quatrième ($T_6$) transistor MOS étant connectées à l'électrode de source du deuxième ($T_4$), respectivement de drain du premier ($T_3$) transistor MOS ;
- un cinquième transistor MOS ($T_7$) dont l'électrode de source est connectée à la tension de référence et l'électrode de grille est connectée audit point commun du troisième et du quatrième transistor MOS ($T_5$, $T_6$), l'électrode de drain dudit cinquième transistor MOS ($T_7$) délivrant ladite valeur complémentée du produit OU exclusif entre lesdites valeurs mémorisées $CAM_{ij}$ et $BL_i$.

**5.** Générateur selon les revendications 1, 3 et 4, **caractérisé en ce que** le couplage de type OU entre cellules mémoire CAM et RAM de même adresse i,j est réalisé par l'intermédiaire d'un transistor MOS ($T_8$) de couplage dont l'électrode de source reliée à l'électrode de drain dudit cinquième transistor MOS ($T_7$) reçoit ladite valeur complémentée du produit OU exclusif entre les valeurs mémorisées $CAM_{ij}$ et $BL_i$, dont l'électrode de grille est connectée au point commun entre le deuxième transistor MOS ($T_2$) et les inverseurs tête-bêche de la cellule mémoire RAM de même adresse i,j, et dont l'électrode de drain délivre ladite valeur résultante

$$HIT_{ij} = (\overline{CAM_{ij} \oplus BL_i}) + M_{ij}.$$

**6.** Générateur selon les revendications 1, 3, 4 et 5, **caractérisé en ce que** le couplage par une fonction logique de type OU de toutes les cellules de comparaison $C_{ij}$ d'une même ligne de rang j est effectué par l'interconnexion en parallèle de toutes les électrodes de drain des transistors MOS ($T_8$) de couplage à une ligne de sortie connectée à la sortie $S_j$ de rang j correspondant.

**7.** Générateur selon l'une des revendications 1 à 6, **caractérisé en ce que** chaque ligne de cellules de comparaison de rang j est dédoublée en une première et une deuxième ligne élémentaire de cellules de comparaison, chaque ligne élémentaire de cellules de comparaison étant programmable indépendamment et complémentairement l'une de l'autre, de façon à délivrer des motifs de trains d'impulsion complémentaires, et interconnectées chacune à une première et une deuxième sortie élémentaire respectivement, ledit générateur comportant en outre, pour chaque couple de première et deuxième ligne élémentaire de cellules de comparaison :

- un circuit logique de type OU interconnecté auxdites première et deuxième sorties élémentaires et délivrant un signal superposition desdits motifs de trains d'impulsion complémentaires ;
- un circuit de type bistable recevant ledit signal superposition et délivrant un signal résultant, dont la résolution temporelle est égale à celle de la période du signal d'horloge de référence.

**Patentansprüche**

1. Elektronischer Pulsgenerator, der in der Dauer und Frequenz programmierbar ist, umfassend m verschiedene programmierbare Ausgänge, Sj, $j \in [0,m-1]$, **dadurch gekennzeichnet, dass** er mindestens umfasst:

   - eine Zeitbasisinitialisierungsschaltung (1), die durch ein Referenztaktsignal (CLK) und durch ein Initialisierungs/Vergleichssignal gesteuert wird, wobei die Zeitbasisinitialisierungsschaltung mindestens m Initialisierungswerte liefert, die über n Bits kodiert sind, für den wahren Wert des Initialisierungssignals, wobei jedes Bit der Initialisierungswerte durch $CAM_{ij}$ bezeichnet wird, $i \in [0,n-1]$, bzw. einen periodischen Zählwert, der über n Bits kodiert ist, für den wahren Wert des Vergleichssignals, wobei jedes Bit des Zählwerts durch BLi bezeichnet wird;

   - Dekodiermittel (2), die eine Vielzahl von Adresswerten $X \in [0,m-1]$ empfangen und auf Wortleitungen ein Schreibsteuerungsadressbit $WL_{1j}$, $WL_{2j}$ liefern;

   - eine Bitvergleichsmatrix, welche $n \times m$ Vergleichszellen ($C_{00}..C_{n-1,m}$) umfassen, die in m Zeilen und n Spalten angeordnet sind, wobei jede Vergleichszelle Cij eine RAM-Speicherzelle und eine CAM-Speicherzelle umfasst, die durch ihren Inhalt adressierbar ist, wobei die Speicherzellen im Schreibzugriff auf den Wortleitungen durch ein Schreibbefehl-Adressbit $WL_{1j}$ bzw. $WL_{2j}$ adressierbar sind, und jeweils zum Speichern das Bit des Ranges i $BL_i$ des Zählwerts empfangen, jede Vergleichszelle mit Adresse i, j einerseits das Speichern des entsprechenden Bits $CAM_{ij}$ des Initialisierungswerts für den wahren Wert des Initialisierungssignals gestattet, und es andererseits gestattet für den wahren Wert des Vergleichssignals einen Wert $\overline{CAM_{ij} \oplus BL_i}$ zu liefern, den komplementären Wert des Exklusiv-Oder-Produkts dieses Bits $CAM_{ij}$ des Initialisierungswerts mit dem Bit $BL_i$ des Zählwerts, wobei jede RAM-Speicherzelle der Adresse i, j einen Bitmaskierungswert liefert, der für den wahren Wert des Initialisierungssignals gespeichert ist, bezeichnet als $M_{ij}$, und jede CAM- und RAM-Speicherzelle der gleichen Adresse i, j durch logische Oder-Kopplung gekoppelt ist, um die Vergleichszelle Cij zu bilden und jede Vergleichszelle einen Ergebniswert

$$HIT_{ij} = \overline{(CAM_{ij} \oplus BL_i)} + M_{ij},$$

   liefert, wobei alle Vergleichszellen $C_{ij}$ einer gleichen Zeile vom Rang j gekoppelt sind durch eine Oder-Logikfunktion am entsprechenden Ausgang $S_j$, was die Durchführung eines Vergleichs gestattet zwischen einem Wort aus n Bits Initialisierungswert, der in den Speicherzellen CAM jeder Zeile des Rangs j für den wahren Wert des Initialisierungssignals gespeichert ist, mit dem Zählwert, der durch die Zeitbasisinitialisierungsschaltung geliefert wird, die für den wahren Wert des Vergleichssignals gesteuert wird, und dadurch auf jedem Ausgang $S_j$ einen programmierten Puls zu erzeugen, der die Beziehung erfüllt:

$$HIT_j = \sum_{i=0}^{n-1} HIT_{ij} = \sum_{i=0}^{n-1} \overline{\left[ (CAM_{ij} \oplus BL_i) + M_{ij} \right]}$$

   gemäß eines periodischen Signals, dessen Periode eine harmonische Periode der Periode des periodischen Zählwerts ist.

2. Generator nach Anspruch 1, **dadurch gekennzeichnet, dass** die gesteuerte Zeitbasisinitialisierungsschaltung umfasst:

   - einen Aufwärts/Abwärts-Zähler (10), der das Taktsignal empfängt und den über n Bits kodierten periodischen Zählwert liefert;

   - eine Multiplexerschaltung (11) welche einerseits die m über n Bits kodierten Initialisierungswerte $CAM_{ij}$ empfängt, und andererseits den über n Bits kodierten Zählwert $BL_i$, der durch den Aufwärts/Abwärts-Zähler geliefert wird, wobei die Multiplexerschaltung die entsprechenden Bitwerte liefert;

   - eine Vielzahl von n Inversverstärkern ($12_0...12_{n-1}$), welche jeweils einen Bitwert empfangen und diesen Bitwert und den komplementären Wert dieses Bitwerts $BLB_i$ liefern.

3. Generator nach einem der Ansprüche 1 oder 2, **dadurch gekennzeichnet, dass** jede Speicherzelle vom RAM-Typ mindestens einen ersten und einen zweiten MOS-Transistor ($T_1$, $T_2$) umfasst, deren Gate-Elektrode parallel geschaltet ist mit der Wortleitung $WL_{1j}$ und deren Source bzw. Drain-Elektrode den Bitwert $BL_i$ bzw. den komplementären Bitwert $BLB_i$ empfängt, und deren Drain- bzw. Source-Elektrode unter Zwischenschaltung von zwei gegeneinandergeschalteten Invertern verbunden sind, wobei der gemeinsame Punkt zwischen den zwei Invertern und der Source-Elektrode des zweiten MOS-Transistors den gespeicherten Wert $M_{ij}$ liefert.

4. Generator nach einem der Ansprüche 1 bis 3, **dadurch gekennzeichnet, dass** die CAM-Speicherzelle mindestens umfasst:

   - einen ersten und einen zweiten MOS-Transistor ($T_3$, $T_4$), deren Gate-Elektrode parallel geschaltet ist mit der Wortleitung $WL_{2j}$, und deren Source- bzw. Drain-Elektrode den Bitwert $BL_i$ bzw. den komplementären Bitwert $BLB_i$ empfängt, und deren Drain- bzw. Source-Elektrode unter Zwischenschaltung von zwei gegeneinandergeschalteten Invertern verbunden ist;

   - einen dritten und einen vierten MOS-Transistor ($T_5$, $T_6$), die über einen gemeinsamen Punkt zwischen ihrer Drain-Elektrode und Source-Elektrode als Kaskade geschaltet sind, wobei die Source-Elektrode des dritten MOS-Transistors ($T_5$) den Bitwert $BL_i$ empfängt, und die Drain-Elektrode des vierten MOS-Transistors ($T_6$) den komplementären Bitwert $BLB_i$ empfängt, die Gate-Elektroden des dritten ($T_5$) und des vierten ($T_6$) MOS-Transistors mit der Source-Elektrode des zweiten ($T_4$) bzw. Drain-Elektrode des ersten ($T_3$) MOS-Transistors verbunden sind;

   - einen fünften MOS-Transistor ($T_7$), dessen Source-Elektrode mit der Referenzspannung verbunden ist, und dessen Gate-Elektrode mit dem gemeinsamen Punkt des dritten und vierten MOS-Transistors ($T_5$, $T_6$) verbunden ist, wobei die Drain-Elektrode des fünften MOS-Transistors ($T_7$) den komplementären Wert des Exklusiv-Oder-Produkts zwischen den gespeicherten Werten $CAM_{ij}$ und $BL_i$ liefert.

5. Generator nach den Ansprüchen 1, 3 und 4, **dadurch gekennzeichnet, dass** die Oder-Kopplung zwischen CAM- und RAM-Speicherzellen der gleichen Adresse i, j verwirklicht wird durch Zwischenschaltung eines MOS-Kopplungstransistors ($T_8$), dessen mit der Drain-Elektrode des fünften MOS-Transistors ($T_7$) verbundene Source-Elektrode den komplimentären Wert des Exklusiv-Oder-Produkts zwischen den gespeicherten Werten $CAM_{ij}$ und $BL_i$ empfängt, dessen Gate-Elektrode mit dem gemeinsamen Punkt zwischen dem zweiten MOS-Transistor, ($T_2$) und den gegeneinander geschalteten Invertern der Speicherzelle RAM der gleichen Adresse i, j verbunden ist und dessen Drain-Elektrode den resultierenden Wert

$$HIT_{ij} = \overline{(CAM_{ij} \oplus BL_i)} + M_{ij},$$

liefert.

6. Generator nach den Ansprüchen 1, 3, 4 und 5, **dadurch gekennzeichnet, dass** die Kopplung durch eine logische Oder-Funktion aller Vergleichszellen $C_{ij}$ einer gleichen Zeile des Rangs j durch parallele Verschaltung aller Drain-Elektroden der MOS-Kopplungstransistoren ($T_8$) mit einer Ausgangsleitung bewirkt wird, die mit dem Ausgang $S_j$ des entsprechenden Rangs j verbunden ist.

7. Generator nach einem der Ansprüche 1 bis 6, **dadurch gekennzeichnet, dass** jede Zeile von Vergleichszellen des Rangs j aufgeteilt ist in eine erste und eine zweite elementare Zeile von Vergleichszellen, wobei jede elementare Zeile von Vergleichszellen unabhängig und komplementär zueinander programmierbar ist, um komplementäre Pulsmuster zu liefern, und mit einem jeweiligen ersten bzw. zweiten elementaren Ausgang verbunden sind, wobei der Generator außerdem für jedes Paar aus erster und zweiter elementarer Zeile von Vergleichszellen umfasst:

   - eine Oder-Logikschaltung, die mit den ersten und zweiten elementaren Ausgängen verbunden ist und ein Überlagerungssignal der komplementären Pulsmuster liefert;

   - eine bistabile Schaltung, welche das Überlagerungssignal empfängt und ein resultierendes Signal liefert, dessen zeitliche Auflösung gleich jener der Periode des Referenztaktsignals ist.

**Claims**

1. Duration and frequency programmable electronic pulse generator comprising m distinct programmable outputs, $S_j$, $j \in [0,m-1]$, **characterized in that** it includes at least:

   - a timebase-initialization circuit (1) driven by a reference clock signal (CLK) and by an initialization/comparison signal, said timebase-initialization circuit delivering at least m initialization values coded on n bits for the true value of the initialization signal, each bit of said initialization values being denoted $CAM_{ij}$, $i \in [0,n-1]$, respectively a periodic count value coded on n bits, for the true value of the comparison signal, each bit of the count value being denoted $BL_i$;
   - decoding means (2) receiving a plurality of address values $X \in [0,m-1]$ and delivering on word lines a write-control address bit $WL_{1j}$, $WL_{2j}$;
   - a bits comparison matrix including n x m comparison cells ($C_{00}$ ... $C_{n-1,m}$) arranged in m rows and n columns, each comparison cell $C_{ij}$ including a RAM memory cell and a CAM memory cell, content-addressable memory cell, said memory cells being write-addressable on said word lines by a write-control address bit $WL_{1j}$ and $WL_{2j}$ respectively, and each receiving for storage the bit of rank i $BL_i$ of said count value, each comparison cell with address i, j making it possible, on the one hand, to store said corresponding bit $CAM_{ij}$ of the initialization value for the true value of the initialization signal and, on the other hand, to deliver for the true value of the comparison signal a value $\overline{CAM_{ij} \oplus BL_i}$, complemented value of the exclusive-OR product of this bit $CAM_{ij}$ of the initialization value and the bit $BL_i$ of said count value, each RAM memory cell with address i, j delivering a masking bit value stored for the true value of the initialization signal, and denoted $M_{ij}$, and each CAM and RAM memory cell of like address i, j being coupled by a logic coupling of the OR type to form said comparison cell $C_{ij}$ and each comparison cell delivering a resulting value

$$HIT_{ij} = \overline{(CAM_{ij} \oplus BL_i)} + M_{ij},$$

   all the comparison cells $C_{ij}$ of the same line of rank j being coupled by a logic function of OR type to the corresponding output $S_j$, this making it possible to perform a comparison between a word of n bits initialization value stored in the CAM memory cells of each line of rank j for the true value of the initialization signal and the count value delivered by the driven timebase-initialization circuit for the true value of the comparison signal and thus to produce on each output $S_j$ a programmed pulse satisfying the relation:

$$HIT_j = \sum_{i=0}^{n-1} HIT_{ij} = \sum_{i=0}^{n-1} [\overline{(CAM_{ij} \oplus BL_i)} + M_{ij}]$$

   according to a periodic signal whose period is a harmonic period of the period of the periodic count value.

2. Generator according to Claim 1, **characterized in that** the said driven timebase-initialization circuit includes:

   - an up/down-counter (10) receiving said clock signal and delivering said periodic count value coded on n bits;
   - a multiplexer circuit (11) receiving, on the one hand, said m initialization values coded on n bits $CAM_{ij}$, and, on the other hand, the count value coded on n bits $BL_i$, delivered by the up/down-counter, the said multiplexer circuit delivering the corresponding bit values;
   - a plurality of n inverter amplifier circuits ($12_0$ ... $12_{n-1}$), each receiving a bit value and delivering this bit value and the complemented value of this bit value $BLBi$.

3. Generator according to either of Claims 1 and 2, **characterized in that** each memory cell of RAM type comprises at least one first and one second MOS transistor ($T_1$, $T_2$) whose gate electrode is connected in parallel with the said word line $WL_{1j}$ and whose source electrode, respectively drain electrode, receives the bit value $BL_i$, respectively the complemented bit value $BLB_i$, and whose drain electrode, respectively source electrode, is linked by way of two inverters connected head-to-tail, the common point between the two inverters and the source electrode of the second MOS transistor delivering the stored value $M_{ij}$.

4. Generator according to one of Claims 1 to 3, **characterized in that** the said CAM memory cell comprises at least:

- one first and one second MOS transistor ($T_3$, $T_4$) whose gate electrode is connected in parallel with the said word line $WL_{2j}$ and whose source electrode, respectively drain electrode, receives the bit value $BL_i$, respectively the complemented bit value $BLB_i$, and whose drain electrode, respectively source electrode, is linked by way of two inverters connected head-to-tail;
- a third and a fourth MOS transistor ($T_5$, $T_6$) connected in cascade by way of a common point between their drain electrode and source electrode, the source electrode of the third MOS transistor ($T_5$) receiving the bit value $BL_i$ and the drain electrode of the fourth MOS transistor ($T_6$) receiving the complemented bit value $BLB_i$, the gate electrodes of the third ($T_5$) and of the fourth ($T_6$) MOS transistor being connected to the source electrode of the second ($T_4$), respectively drain electrode of the first ($T_3$) MOS transistor;
- a fifth MOS transistor ($T_7$) whose source electrode is connected to the reference voltage and whose gate electrode is connected to the said common point of the third and of the fourth MOS transistor ($T_5$, $T_6$), the drain electrode of the said fifth MOS transistor ($T_7$) delivering the said complemented value of the exclusive-OR product between the said stored values $CAM_{ij}$ and $BL_i$.

5. Generator according to Claims 1, 3 and 4, **characterized in that** the OR type coupling between CAM and RAM memory cells of like address i, j is effected by way of a MOS coupling transistor ($T_8$) whose source electrode linked to the drain electrode of the said fifth MOS transistor ($T_7$) receives the said complemented value of the exclusive-OR product between the stored values $CAM_{ij}$ and $BL_i$, whose gate electrode is connected to the common point between the second MOS transistor ($T_2$) and the head-to-tail inverters of the RAM memory cell of like address i, j, and whose drain electrode delivers the said resulting value

$$HIT_{ij} = \overline{(CAM_{ij} \oplus BL_i)} + M_{ij}.$$

6. Generator according to Claims 1, 3, 4 and 5, **characterized in that** the coupling by a logic function of OR type of all the comparison cells $C_{ij}$ of the same line of rank j is performed by the interconnecting in parallel of all the drain electrodes of the MOS coupling transistors ($T_8$) to an output line connected to the output $S_j$ of corresponding rank j.

7. Generator according to one of Claims 1 to 6, **characterized in that** each line of comparison cells of rank j is split into a first and a second elementary line of comparison cells, each elementary line of comparison cells being programmable independently and complementarily the one from the other, so as to deliver patterns of complementary pulse trains, and each interconnected to a first and a second elementary output respectively, the said generator furthermore including, for each first and second elementary line pair of comparison cells:

- an OR type logic circuit interconnected to the said first and second elementary outputs and delivering a superposition signal for the said patterns of complementary pulse trains;
- a circuit of bistable type receiving the said superposition signal and delivering a resulting signal whose temporal resolution is equal to that of the period of the reference clock signal.

HORLOGE → COMPTEUR $2^n$ ← VALIDATION COMPTEUR

ORDRE DE COMPARAISON

CHARGEMENT DU MODULE 0 →
CHARGEMENT DU MODULE 1 →

CIRCUIT DE MODULES EN PARALLELE

CHARGEMENT DU MODULE n →

→ PWM 0
→ PWM 1

→ PWm

EXEMPLE
$MOT(0) = 2$
$MOT(1) = 2^{n-1}$
$MOT(m) = 4$

## FIG. 1a.
(ART ANTÉRIEUR)

CHARGEMENT
DES MODULES

VALIDATION
COMPTEUR

ÉTAT DU
COMPTEUR          0  1  2  3  4        $2^{n-1}$  $2^n$  0  1

PWM 0

PWM 1

PWM m

## FIG. 1b.
(ART ANTÉRIEUR)

FIG.1c.
(ART ANTÉRIEUR)

FIG.1d.
(ART ANTÉRIEUR)

# FIG.2a.

CHRONOGRAMME DE PRINCIPE DE FONCTIONNEMENT

INITIALISATION/COMPARAISON
I/C

m VALEURS D'INITIALISATION — CAM1 CAM2 CAM-x RAM1 RAM2 RAM-m

ADRESSES A(m.0)

WL2(m.0)

WL1(m.0)

ÉTATS COMPTEUR

CHARGEMENT DES DONNÉES À COMPARER EN POINTS MÉMOIRE CAM

CHARGEMENT DES MASQUES EN POINTS MÉMOIRE RAM

PHASE ·D'INITIALISATION APÉRIODIQUE

PHASE DE COMPTAGE/COMPARAISON PÉRIODIQUE

FIG.2b.

EP 0 817 378 B1

BLi    BLBi

T3    T4    WL2j

CAM
ij    L2

BL

T5    T6    0v

CELLULE
CAM    T7

N8

T8

HITij

# FIG.2c.

$$HITij = \overline{(CAMij \oplus \overline{BLi}) + Mij}$$

T1    T2    WL1j

N1    N2
Mij    L1

CELLULE RAM

Cij

CHRONOGRAMME DE LA FONCTION HITij

PRÉCHARGE

BLi

CAMij

ORDRE DE
COMPARAISON

MASQUE Mij

HITij

HITij NÉGATIF    HITij POSITIF    HIT POSITIF

# FIG.2d.

FIG.2e. EXEMPLE DE SORTIE PWM AVEC COMPTEUR $2^5$ ET VALEUR PRÉCHARGÉE A 10010

ÉTATS DU COMPTEUR/BASE DE TEMPS

$2^4$ | 0 0 0 0 0 0 0 0 0 0 0 0 0 0 0 0 1 1 1 1 1 1 1 1 1 1 1 1 1 1 1 1
$2^3$ | 0 0 0 0 0 0 0 0 1 1 1 1 1 1 1 1 0 0 0 0 0 0 0 0 1 1 1 1 1 1 1 1
$2^2$ | 0 0 0 0 1 1 1 1 0 0 0 0 1 1 1 1 0 0 0 0 1 1 1 1 0 0 0 0 1 1 1 1
$2^1$ | 0 0 1 1 0 0 1 1 0 0 1 1 0 0 1 1 0 0 1 1 0 0 1 1 0 0 1 1 0 0 1 1
$2^0$ | 0 1 0 1 0 1 0 1 0 1 0 1 0 1 0 1 0 1 0 1 0 1 0 1 0 1 0 1 0 1 0 1

$2^4 2^3 2^2 2^1 2^0$ CONTENU D UNE LIGNE DE CAM

COMPARAISON STRICTE — 10010

1 — 1001X

2 — 100XX

3 — X0010

4 — 1X010

5 — 10X10

6 — 100X0

7 — 1X0X0

d2   d1

8 — 10XX0

EP 0 817 378 B1

FIG.3a.

EP 0 817 378 B1

# FIG.3b.

| $2^4$ | 0 | 0 | 0 | 0 | 0 | 0 | 0 | 0 | 0 | 0 | 0 | 0 | 0 | 0 | 0 | 0 | 1 | 1 | 1 | 1 | 1 | 1 | 1 | 1 | 1 | 1 | 1 | 1 | 1 | 1 | 1 | 1 | 0 | 0 | 0 | 0 | 0 | 0 |
|---|---|---|---|---|---|---|---|---|---|---|---|---|---|---|---|---|---|---|---|---|---|---|---|---|---|---|---|---|---|---|---|---|---|---|---|---|---|---|
| $2^3$ | 0 | 0 | 0 | 0 | 0 | 0 | 0 | 0 | 1 | 1 | 1 | 1 | 1 | 1 | 1 | 1 | 0 | 0 | 0 | 0 | 0 | 0 | 0 | 0 | 1 | 1 | 1 | 1 | 1 | 1 | 1 | 1 | 0 | 0 | 0 | 0 | 0 | 0 |
| $2^2$ | 0 | 0 | 0 | 0 | 1 | 1 | 1 | 1 | 0 | 0 | 0 | 0 | 1 | 1 | 1 | 1 | 0 | 0 | 0 | 0 | 1 | 1 | 1 | 1 | 0 | 0 | 0 | 0 | 1 | 1 | 1 | 1 | 0 | 0 | 0 | 0 | 1 | 1 |
| $2^1$ | 0 | 0 | 1 | 1 | 0 | 0 | 1 | 1 | 0 | 0 | 1 | 1 | 0 | 0 | 1 | 1 | 0 | 0 | 1 | 1 | 0 | 0 | 1 | 1 | 0 | 0 | 1 | 1 | 0 | 0 | 1 | 1 | 0 | 0 | 1 | 1 | 0 | 0 |
| $2^0$ | 0 | 1 | 0 | 1 | 0 | 1 | 0 | 1 | 0 | 1 | 0 | 1 | 0 | 1 | 0 | 1 | 0 | 1 | 0 | 1 | 0 | 1 | 0 | 1 | 0 | 1 | 0 | 1 | 0 | 1 | 0 | 1 | 0 | 1 | 0 | 1 | 0 | 1 |

$HIT_{0j}$ — X0011

$HIT_{1j}$ — 10000

$PWM_j$

13 T   3T

PÉRIODE BASE DE TEMPS

EP 0 817 378 B1